# EUROPÄISCHE PATENTSCHRIFT

(11) **EP 2 394 975 B1**
(45) Veröffentlichungstag und Bekanntmachung des Hinweises auf die Patenterteilung: **17.04.2013**
(21) Anmeldenummer: 11004835.2
(22) Anmeldetag: 14.06.2011
(51) Int. Cl.: C04B 37/02, H05K 3/38

(54) **Verfahren zum Herstellen von doppelseitig metallisierten Metall-Keramik-Substraten**
Method for producing metal-ceramic substrates metallised on both sides
Procédé de fabrication de substrats en céramique et métal métallisés sur les deux faces

(30) Priorität: 14.06.2010 DE 102010023637
(43) Veröffentlichungstag der Anmeldung: 14.12.2011
(73) Patentinhaber: IXYS Semiconductor GmbH, D-68623 Lampertheim (DE)
(72) Erfinder: Weidenauer, Werner, 68623 Lampertheim (DE); Spann, Thomas, 64658 Fürth (DE); Knoll, Heiko, 35037 Marburg (DE)
(74) Vertreter: Oppermann, Frank

(56) Entgegenhaltungen:
- EP-A1- 0 219 254
- EP-A2- 0 525 820
- DE-A1- 3 137 570
- DE-A1-102004 033 933
- DE-A1-102004 056 879
- US-A- 4 409 278

## Beschreibung

Die Erfindung betrifft ein Verfahren zum Herstellen von doppelseitig metallisierten Metall-Keramik-Substraten nach dem Direct-Bonding-Prozess.

Doppelseitig metallisierte Metall-Keramik-Substrate sind allgemein bekannt. Derartige Metall-Keramik-Substrate finden insbesondere im Bereich von Leistungshalbleitermodulen als Schaltungsträger Verwendung. Es handelt sich bei den Schaltungsträgern um eine auf Ober- und Unterseite mit einer Cu-Metallisierung versehene Keramik, bei der mindestens eine metallisierte Seite eine schaltungstechnische Struktur aufweist. Das bekannte Verfahren zum Herstellen dieser Metall-Keramik-Verbunde mittels eutektischem Bonden wird allgemein als Direct-Bonding-Prozess bezeichnet (Direct-Copper-Bonding DCB).

Die US 3994430 und die EP 0085914 beschreiben ein Verfahren zur Herstellung von Metall-Keramik-Substraten nach dem Direct-Bonding-Prozess. Den bekannten Herstellungsverfahren ist gemeinsam, dass die Verbindungsbildung zwischen Metallplatte bzw. -folie und Keramik durch einen Flüssigphasen-Bondprozess erfolgt. Dazu wird das lokale Aufschmelzen einer auf die Metallplatte aufgetragenen Zwischenschicht, deren Schmelzpunkt (Eutektikum) unterhalb des Schmelzpunktes des Metalls und der Keramik liegt, ausgenutzt.

Der bekannte Direct-Bonding-Prozess umfasst grundsätzlich die folgenden Verfahrensschritte:
- Aufbringen einer geeigneten Schicht auf mindestens eine Seite der unstrukturierten Metallplatte zur Erzeugung einer eutektischen Aufschmelzschicht
- Auflegen der unstrukturierten Metallplatte mit der Aufschmelzschicht auf die Oberseite einer unstrukturierten Keramik
- Erhitzen von Metallplatte und Keramik auf eine Temperatur, die über dem Schmelzpunkt der Aufschmelzschicht und unterhalb des Schmelzpunktes der zu fügenden Werkstoffe liegt
- Abkühlen des Verbundes auf Raumtemperatur und
- ggf. Schleifen und Polieren der gebondeten Metallschicht zur Beseitigung lokaler Unebenheiten, die durch den Bondprozess entstanden sind.

Bei dem aus der US 3994430 bekannten Verfahren erweist sich als nachteilig, dass die Bondung der Metallplatten an der Ober- und Unterseite der Keramik vorzugsweise in zwei Schritten zu erfolgen hat, da bei gleichzeitiger Bondung beider Metallplatten die untere Metallplatte mit dem Substratträger verkleben und das nachträgliche Ablösen zu Beschädigungen des Metall-Keramik-Substrats führen würde. Somit sind für die Herstellung von beidseitig metallisierten Metall-Keramik-Substraten mindestens zwei Prozessschritte erforderlich, was zeit- und kostenintensiv ist.

Die DE 10 2004 056 879 A1 beschreibt ein Verfahren zum gleichzeitigen Bonden von zwei Metallfolien an eine Keramik. Bei dem bekannten Verfahren soll das Verkleben der unteren Metallfolie mit dem Substratträger durch die Zwischenlage einer zusätzlichen Trennschicht verhindert werden, die aus einem porösen Material bestehen soll. Nachteilig ist, dass die erforderliche Trennschicht zunächst mit geeigneten Mitteln aufzubringen und nach dem Bondprozess mit entsprechenden Verfahren wieder von der Metalloberfläche zu entfernen ist, was mit einem zusätzlichen Zeit- und Kostenaufwand verbunden ist. Zwar ist aus der DE 10 2004 056 879 A1 auch ein Substratträger bekannt, der an der Oberfläche mit einer Vielzahl von Nuten versehen ist. Aber auch auf diesen Substratträger soll eine Trennschicht aufgebracht werden.

Ein weiteres Problem beim Fügen von Metall-Keramik-Substraten mittels eines Flüssigphasen-Bondprozesses besteht darin, dass die Bondung zwischen Metallplatte und Keramik-Substrat teilweise nicht 100%ig vollflächig erfolgt. Die in der Grenzfläche zwischen Metall und Keramik entstehenden Einschlüsse wirken sich vor allem auf die Teilentladungsfestigkeit der Substrate negativ aus und stören lokal die thermische sowie mechanische Anbindung zwischen Metall und Keramik.

Die US 44092278, US 4860939 und DE 102004033933 beschreiben Verfahren, bei denen die Blasenbildung verringert bzw. die gebondete Fläche vergrößert werden sollen. Die US 44092278 schlägt vor, "Entlüftungslinien" in die Metallplatte oder Keramik einzubringen. Nachteilig ist, dass sich in diesen Strukturen bei den für den Aufbau der Leistungshalbleitermodule notwendigen Fügeprozessen Prozessflüssigkeiten ansammeln können, beispielsweise Flussmittel beim Löten. Prozessflüssigkeiten können während des Einsatzes der Module austreten und die Lebensdauer der Bauteile verringern. Des weiteren reduzieren die "Entlüftungslinien" die thermische und elektrische Ankopplung zwischen Metall und Keramik.

Die US 4860939 schlägt vor, die Blasenbildung durch ein intensives Reinigen der Oberflächen von Metallplatte und Keramik zu vermeiden. Dies soll hierbei vor allem durch die in-situ Bildung der zum Flüssigphasenbonden notwendigen Reaktionsschicht erreicht werden. Dies erscheint allerdings in der Praxis als wenig aussichtsreich, da es neben den eventuell anhaftenden Verschmutzungen noch andere Ursachen für die Blasenbildung gibt.

Bei dem in der DE 102004033933 beschriebenen Verfahren sollen die während des Bondprozesses entstandenen Blasen in einem nachgeschalteten Prozess durch sehr hohen Druck (400 bis 2000 bar) und hohe Temperatur (450 bis 1050°C) aus der Grenzfläche herausgedrückt werden. Nachteilig ist, dass der bekannte Prozess zum Entfernen der Blasen sehr energie-, zeit- und somit kostenintensiv ist, weshalb das Verfahren für die Massenproduktion weitgehend ungeeignet ist.

Die EP 0 525 820 A2 und EP 0 219 254 A1 schlagen vor, Rinnen oder Nuten in einer mit einem Keramiksubstrat zu verbindenden Metallplatte vorzusehen. Die DE 3137 570 A1 beschreibt ein Verfahren zur blasenfreien Verbindung von Kupferfolien mit Oxidkeramiksubstraten, wobei auf das Oxidkeramiksubstrat Kontaktstifte und/oder Befestigungsbügel aufgebracht werden.

Der Erfindung liegt die Aufgabe zugrunde, ein einfach und kostengünstig durchzuführendes Verfahren zum Herstellen von doppelseitig metallisierten Metall-Keramik-Substraten nach dem Direct-Bonding-Prozess anzugeben. Die Lösung dieser Aufgabe erfolgt erfindungsgemäß mit den Merkmalen des Patentanspruchs 1. Bevorzugte Ausführungsformen der Erfindung sind Gegenstand der Unteransprüche.

Das erfindungsgemäße Verfahren ermöglicht es, mindestens ein Keramiksubstrat an der Ober- und Unterseite in nur einem Prozessdurchlauf mit jeweils einer Metallplatte bzw. -folie zu verbinden, wobei es sich bei diesem Fügeprozess um eine Flüssig-Phasen-Bondung handelt. Dies wird erfindungsgemäß dadurch erreicht, dass sich der zu fügeende Verbund auf einem besonders ausgestalteten Träger befindet. Dieser Träger ist erfindungsgemäß dadurch gekennzeichnet, dass der Träger an der Oberseite unter Bildung einer Vielzahl von Auflagepunkten strukturiert ist. Der Träger kann aus nur einem Teil, oder aus mehreren Teilen bestehen. Allein entscheidend ist, dass der Träger an der Oberfläche erfindungsgemäß strukturiert ist.

Die aus der ersten und zweiten Metallplatte und dem Keramiksubstrat bestehende Anordnung wird auf den erfindungsgemäßen Träger aufgelegt. Aufgrund der besonderen Strukturierung des erfindungsgemäßen Trägers wird erreicht, dass sich der Verbund von Metallplatten und Keramiksubstrat nach dem Bondprozess rückstandsfrei von dem Träger lösen lässt und gegebenenfalls nach einer Reinigung wiederverwendet werden kann. Der erfindungsgemäßen Träger bietet den Vorteil, dass eine zusätzliche Trennschicht nicht erforderlich ist, die erst auf den Träger aufgebracht werden müsste. Der Zwischenraum zwischen Träger und Anordnung stellt auch sicher, dass ein guter Wärmeübergang beim Erhitzen im Ofen gewährleistet ist. Somit wird das Verfahren zum Herstellen der doppelseitig metallisierten Metall-Keramik-Substrate vereinfacht.

Die Anzahl und Größe der Auflagepunkte sollte derart bemessen sein, dass die Anordnung aus Metallplatten und Keramiksubstrat einerseits ausreichend auf dem Träger abgestützt ist und andererseits ein ausreichender Zwischenraum zwischen der Anordnung und dem Träger vorhanden ist.

Vorzugsweise haben die Ansätze ein Höhe, die kleiner als 100 mm, besonders bevorzugt keiner als 50 mm, insbesondere kleiner als 10 mm ist.

Der Träger weist an der Oberseite, die der Anordnung aus der ersten und zweiten Metallplatte und dem Keramiksubstrat zugewandt ist, eine Vielzahl von vorspringenden Ansätzen auf. Die vorspringenden Ansätze verjüngen sich in Richtung der Anordnung. Vorzugsweise laufen die vorspringenden Ansätze in Richtung der Anordnung spitz zu. Damit wird eine Vielzahl von kleinen Auflagepunkten geschaffen. Die "spitz zulaufenden" Ansätze an der Oberseite beschreiben vorzugsweise eine punktförmige "Auflagefläche", die beispielsweise zwischen 1 und 3 mm² pro Ansatz, insbesondere 2 mm² liegen kann, da sich kleinere Auflageflächen in der Praxis aus produktionstechnischen Gründen nur schwierig und/oder kostspielig herstellen lassen und eine weitere Verkleinerung der Auflagefläche nicht erforderlich oder erwünscht ist. So könnten noch kleinere Auflageflächen auch zu Beschädigungen des Substrats führen.

Die Auflagefläche, die durch die Gesamtheit aller vorspringenden Ansätze auf dem Träger geschaffen wird, liegt im Verhältnis zu der zu bondenden Fläche vorzugsweise zwischen 0,1 bis 0,5 %, insbesondere 0,3 %.

Besonders bevorzugt werden kegelförmige oder pyramidenförmige Körper als vorspringende Ansätze. Die vorspringenden Ansätze können aber auch zylinderförmig sein. Sie können auch einen quadratischen und/oder rechteckförmigen und/oder ovalen Querschnitt oder den Querschnitt einer Ellipse haben. Allein entscheidend ist, dass die Anordnung nicht vollflächig, sondern in Bezug auf gesamte Fläche der Unterseite nur auf einer verhältnismäßig sehr kleinen Fläche auf den vorspringenden Ansätzen aufliegt.

Die vorspringenden Ansätze sind vorzugsweise in Reihen und Spalten vorzugsweise in gleichbleibenden Abständen über die gesamte Oberseite verteilt angeordnet.

Der Träger sollte aus einem auf den Bondprozess bezogenen reaktionsträgen und/oder nicht benetzbaren Material, beispielsweise aus einem hochtemperaturfesten Metall bestehen, wobei der Träger gegebenenfalls nach einer Reinigung wieder verwendet werden kann. Er sollte aus einem Material bestehen, das für unterschiedliche Prozessatmosphären (reaktiv und inert) verwendet werden kann.

Der Träger oder Teile des Trägers weisen vorzugsweise mindestens eine der Verbindungen ausgewählt aus der Gruppe bestehend aus Mullit, Aluminium-Nitrid, Bor-Nitrid, Silizium-Nitrid, Zirkonium-Nitrid, Siliziumkarbid und Graphit auf.

Bei dem erfindungsgemäßen Verfahren wird eine Blasenbildung dadurch wirkungsvoll vermieden, dass die erste und/oder zweite Metallplatte vor dem Aufbringen auf das Keramiksubstrat perforiert wird. Die Perforation vorzugsweise beider Metallplatten ermöglicht, dass sich während des Bondprozesses in der Grenzfläche von Metallplatte und Keramik entstehende Blasen "entlüften" können. Dadurch wird die Fläche, an der die Bondung stattfindet, vergrößert.

Die Perforation zumindest einer der beiden Metallplatten ist von eigener erfinderischer Bedeutung. Vorzugsweise findet bei dem Verfahren zum Herstellen von doppelseitig metallisierten Metall-Keramik-Substraten sowohl der erfindungsgemäß strukturierte Träger als auch die erfindungsgemäß perforierten Metallplatten bzw. -folien Verwendung. Es ist aber grundsätzlich auch möglich, dass nur die erfindungsgemäß perforierten Metallplatten, nicht aber der erfindungsgemäße Träger verwendet wird.

Vorzugsweise wird zumindest eine der beiden Metallplatten mit Löchern versehen, die einen Durchmesser haben, der ausreichend groß ist, um eine "Entlüftung" zu gewährleisten, andererseits ausreichend klein ist, um sicherzustellen, dass die Metallplatte eine ausreichend große Stromtragfähigkeit hat. Vorzugsweise haben die Löcher einen Durchmesser, der zwischen 0,1 - 1 mm, vorzugsweise 0,4 - 0,6 mm liegt.

Die Löcher werden vorzugsweise in Reihen und Spalten, vorzugsweise in gleichbleibenden Abständen angeordnet. Grundsätzlich ist aber jede beliebige Verteilung der Löcher auf der Metallplatte möglich.

Im Folgenden werden Ausführungsbeispiele der Erfindung unter Bezugnahme auf die Figuren näher erläutert.

Es zeigen:
- Fig. 1: ein DCB-Paket in geschnittener Darstellung, das ein zwischen einer oberen und unteren Metallplatte oder -folie angeordnetes Keramik-Substrat aufweist,
- Fig. 2: das auf einem Träger aufliegende DCB-Paket von Fig. 1,
- Fig. 3: einer der beiden Metallplatten oder -folien des DCB-Pakes von Fig. 1,
- Fig. 4: ein alternatives Ausführungsbeispiel eines Trägers für das DCB-Paket und
- Fig. 5: ein weiteres Ausführungsbeispiel eines Trägers für das DCB-Paket.

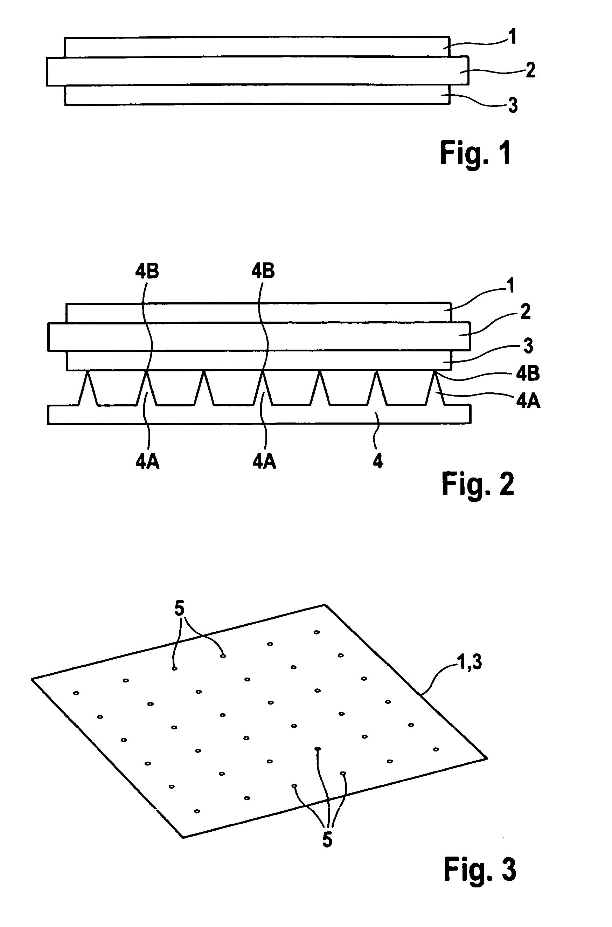

Fig. 1 zeigt die als DCB-Paket bestehende Anordnung aus einer ersten oberen Metallplatte 1 und einer zweiten unteren Metallplatte 3, zwischen denen ein Keramik-Substrat 2 liegt. Die Metallplatten 1,2 sind Kupferplatten bzw. -folien. Das Keramiksubstrat ist ein Oxidkeramiksubstrat, insbesondere eine Aluminiumoxidkeramik.

Das als Direct-Bonding-Prozess bekannte Verfahren zum Verbinden der oxidierten Metallplatten 1 und 3 mit dem Keramik-Substrat 2 ist in der EP 0085914 im Einzelnen beschrieben, auf die ausdrücklich Bezug genommen wird.

Das erfindungsgemäße Verfahren zeichnet sich dadurch aus, dass das DCB-Paket auf einen besonders strukturierten Träger 4 aufgelegt wird (Fig. 2). Der Träger 4 ist eine Platte aus mindestens eine der Verbindungen ausgewählt aus der Gruppe bestehend aus Mullit, Aluminium-Nitrid, Bor-Nitrid, Silizium-Nitrid, Zirkonium-Nitrid, Siliziumkarbid und Graphit. Die Platte weist an der Oberseite, die dem DCB-Paket 1, 2, 3 zugewandt ist, eine Vielzahl von vorspringenden Ansätzen 4A auf. Die Höhe H dieser Erhebungen liegt vorzugsweise zwischen 0 < H ≤ 20 mm. Die vorspringenden Ansätze 4A sind bei dem Ausführungsbeispiel kegelförmige Körper mit einer Höhe von ca. 10 mm, deren Spitzen 4B nach außen weisen. Die Spitzen 4B der kegelförmigen Körper 4A bilden Auflagepunkte, an denen das DCB-Substrat 1, 2, 3 auf dem Träger 4 aufliegt. Die kegelförmigen Körper 4 sind in Reihen und Spalten in gleichbleibenden Abständen angeordnet.

Beim ersten Ausführungsbeispiel wurde ein Keramiksubstrat aus Al₂O₃ mit einer Dicke von 0,38 mm und einer Größe von 138 mm x 190 mm beidseitig mit jeweils einer 0,3 mm dicken Metallfolie aus Kupfer verbunden. Vor dem Bondprozess wurden die Kupferfolien 1, 3 in bekannter Weise beidseitig oxidiert. Aus den beiden Metallfolien 1, 3 und dem Keramiksubstrat 2 wurde das in Fig. 1 gezeigte DCB-Paket aufgebaut. Das DCB-Paket 1, 2, 3 wurde dann auf den in Fig. 2 gezeigten Träger aufgelegt und auf das Transportband eines Durchlaufofens aufgesetzt. In dem Durchlaufofen wurde das auf dem Träger 4 aufliegende DCB-Paket 1, 2, 3 mit einer konstanten Transportgeschwindigkeit auf eine Temperatur zwischen 1065°C und 1083°C, beispielsweise 1071°C, aufgeheizt und nach dem Durchlaufen der Heizzonen des Ofens wieder auf Raumtemperatur abgekühlt. Nach diesem Bondprozess wurde das Metall-Keramik-Substrat 1, 2, 3 vom Träger 4 abgesetzt und entsprechend den bekannten Technologien der DCB-Herstellung bearbeitet. Der Träger 4 wurde nach dem Bondvorgang gereinigt, um für den nächsten Bondvorgang wieder zur Verfugung zu stehen. Es zeigte sich, dass auf eine zusätzliche Trennschicht zwischen der Unterseite der unteren Metallfolie 3 und dem Träger 4 verzichtet werden konnte, ohne dass die Gefahr des Verklebens der Metallfolie mit dem Träger bestand.

Die Metallfolien 1, 3 des DCB-Pakets 1, 2, 3 wurden vor dem Auflegen auf das Metall-Keramik-Substrat 2 perforiert. Zur Perforation wurde ein Laser eingesetzt, mit dem die Kupferfolien in Reihen und Spalten in einem Abstand von 20 mm mit Löchern 5 mit einem Durchmesser von 0,5 mm versehen wurden. Nach dem Perforieren, aber vor dem Bondprozess wurden die Kupferfolien oxidiert. Vor dem Bondprozess wurden die perforierten und oxidierten Kupferfolien 1, 3 auf das Keramik-Substrat 2 aufgelegt. Dieser Verbund wurde auf das Transportband des Durchlaufofens aufgebracht und bei konstanter Transportgeschwindigkeit auf eine Temperatur zwischen 1065°C und 1083°C, beispielsweise 1071°C, aufgeheizt und nach dem Durchlaufen der Heizzonen des Ofens wieder auf Raumtemperatur abgekühlt. Es zeigte sich keine Blasenbildung zwischen Kupferfolien Keramik-Substrat.

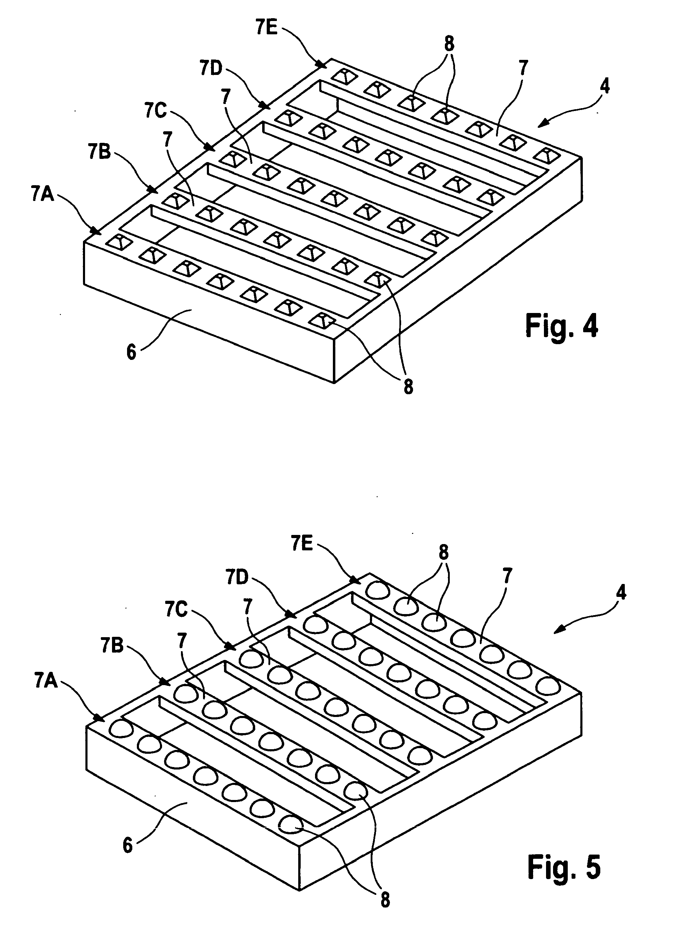

Fig. 4 zeigt ein alternatives Ausführungsbeispiel des Trägers 4 für das DCB-Paket 1,2,3. Der Träger 4 ist als rechteckförmiger Rahmen 6 mit querverlaufenden Stegen 7 ausgebildet. An der Oberseite der querverlaufenden Stege 6 sind in Reihen 7A bis 7E vorspringende Ansätze angeordnet, die als stumpfe vierseitige Pyramiden 8 ausgebildet sind. Anstelle von vierseitigen Pyramiden können aber auch pyramidenförmige Körper vorgesehen sein, die mehr als oder weniger als vier Seiten aufweisen. Die abgeflachten Spitzen der Pyramiden bilden die Flächen, an den das DCB-Substrat aufliegt.

Fig. 5 zeigt ein weiteres Ausführungsbeispiel des Trägers 4 für das DCB-Paket 1,2,3. Die Ausführungsform von Fig. 6 unterscheidet sich von dem Ausführungsbeispiel von Fig. 4 nur durch die Ausbildung der vorspringenden Ansätze. Daher werden für die einander entsprechenden Teile die gleichen Bezugszeichen verwendet. Der Träger ist wieder als rechteckförmiger Rahmen 6 mit querverlaufenden Stegen 7 ausgebildet. An der Oberseite der querverlaufenden Stege 6 sind in Reihen 7A bis 7E vorspringende Ansätze angeordnet, die als halbkugelförmige Körper 9 ausgebildet sind. Anstelle von Körpern mit einem kreisförmigen Querschnitt können aber auch Körper mit einem ovalen Querschnitt oder dem Querschnitt einer Ellipse vorgesehen sein.

## Patentansprüche

1. Verfahren zum Herstellen von doppelseitig metallisierten Metall-Keramik-Substraten nach dem Direct-Bonding-Prozess, wobei
eine Anordnung aus einer ersten Metallplatte und einer zweiten Metallplatte und einem zwischen der ersten und zweiten Metallplatte angeordneten Keramiksubstrat auf einen Träger aufgelegt wird, der an der Oberseite, die der Anordnung aus der ersten und zweiten Metallplatte und dem Keramiksubstrat zugewandt ist, unter Bildung einer Vielzahl von Auflagepunkten strukturiert ist, und
die auf dem Träger aufliegende Anordnung aus der ersten und zweiten Metallplatte und dem Keramiksubstrat durch Erhitzen zu dem doppelseitig metallisierten Metall-Keramik-Substrat verbunden wird,
**dadurch gekennzeichnet, dass**
der Träger an der Oberseite, die der Anordnung aus der ersten und zweiten Metallplatte und dem Keramiksubstrat zugewandt ist, eine Vielzahl von vorspringenden Ansätzen aufweist, die sich in Richtung der Anordnung aus der ersten und zweiten Metallplatte und dem Keramiksubstrat verjüngen, wobei
die Anordnung aus der ersten Metallplatte und der zweiten Metallplatte und dem zwischen der ersten und zweiten Metallplatte angeordneten Keramiksubstrat auf die vorspringenden Ansätze des Trägers ohne Zwischenlage einer Trennschicht aufgelegt wird.

2. Verfahren nach einem der Ansprüche 1, **dadurch gekennzeichnet, dass** die vorspringenden Ansätze in Richtung der Anordnung aus der ersten und zweiten Metallplatte und dem Keramiksubstrat spitz zulaufen.

3. Verfahren nach Anspruch 1 oder 2, **dadurch gekennzeichnet, dass** die vorspringenden Ansätze kegelförmige Körper sind.

4. Verfahren nach Anspruch 1 oder 2, **dadurch gekennzeichnet, dass** die vorspringenden Ansätze pyramidenförmige Körper sind.

5. Verfahren nach Anspruch 1 oder 2, **dadurch gekennzeichnet, dass** die vorspringenden Ansätze halbkugelförmige Körper sind.

6. Verfahren nach einem der Ansprüche 1 bis 5, **dadurch gekennzeichnet, dass** die vorspringenden Ansätze an der Oberseite des Trägers, die der Anordnung aus der ersten und zweiten Metallplatte und dem Keramiksubstrat zugewandt ist, in gleichbleibenden Abständen verteilt angeordnet sind.

7. Verfahren nach einem der Ansprüche 1 bis 6, **dadurch gekennzeichnet, dass** der _ Träger oder zumindest Teile des Trägers mindestens eine der Verbindungen ausgewählt aus der Gruppe bestehend aus Mullit, Aluminium-Nitrid, Bor-Nitrid, Silizium-Nitrid, Zirkonium-Nitrid, Siliziumkarbid und Graphit aufweisen.

8. Verfahren nach einem der Ansprüche 1 bis 7, **dadurch gekennzeichnet, dass** die Metallplatten vor dem Auflegen auf das Keramiksubstrat oxidiert werden.

9. Verfahren nach einem der Ansprüche 1 bis 8, **dadurch gekennzeichnet, dass** als Metallplatten Kupferplatten verwendet werden.

10. Verfahren nach einem der Ansprüche 1 bis 9, **dadurch gekennzeichnet, dass** die erste und/oder zweite Metallplatte vor dem Aufbringen auf das Keramiksubstrat perforiert wird.

11. Verfahren nach Anspruch 10, **dadurch gekennzeichnet, dass** die erste und/oder zweite Metallplatte vor dem Aufbringen auf das Keramiksubstrat mit Löchern versehen wird, die einen Durchmesser haben, der zwischen 0,1 bis 1 mm, vorzugsweise 0,4 bis 0,6 mm liegt.

12. Verfahren nach Anspruch 10 oder 11, **dadurch gekennzeichnet, dass** die Löcher in Reihen und Spalten vorzugsweise in gleichbleibenden Abständen angeordnet sind.

## Claims

1. Method for the production of double-sided metallised ceramic substrates according to the direct bonding process, whereby
an arrangement comprising a first metal plate and a second metal plate and a ceramic substrate arranged between the said first and second metal plates is placed on a carrier, whose upper side, which faces towards the said arrangement of the first and second metal plate and the ceramic substrate, is structured in such a way that a plurality of contact points is formed, and
the arrangement of the said first and second metal plates and the ceramic substrate is bonded to the double-sided metallised ceramic substrate by heating,
**characterised in that**
the upper side of the carrier that faces the said arrangement of the first and second metal plates comprises a plurality of projecting contact points, which are tapered in the direction of the said arrangement of the first and second metal plates and the ceramic substrate, whereby
the said arrangement of the first and second metal plates and the ceramic substrate arranged between the said first and second metal plates is placed on the projecting contact points of the carrier without the interpositioning of a separating layer.

2. A method according to Claim 1 above, **characterised in that** the contacts projecting in the direction of the said first and second metal plates and the ceramic substrate are pointed.

3. A method according to Claim 1 or Claim 2 above, **characterised in that** the projecting contacts are conical bodies.

4. A method according to Claim 1 or Claim 2 above, **characterised in that** the projecting contacts are in the form of pyramid bodies.

5. A method according to Claim 1 or Claim 2 above, **characterised in that** the projecting contacts are hemispherical bodies.

6. A method according to any of the preceding Claims 1 to 5, **characterised in that** the projecting contacts on the upper side of the carrier that faces the said arrangement of the first and second metal plate and the ceramic substrate are spaced at equal intervals.

7. A method according to any of the preceding Claims 1 to 6, **characterised in that** the carrier, or at least parts thereof, comprises at least one compound selected from the group consisting of mullite, aluminium nitride, boron nitride, silicon nitride, zirconium nitride, silicon carbide and graphite.

8. A method according to any of the preceding Claims 1 to 7, **characterised in that** the said metal plates are oxidised before being placed on the ceramic substrate.

9. A method according to any of the preceding Claims 1 to 8, **characterised in that** copper plates are used as the said metal plates.

10. A method according to any of the preceding Claims 1 to 9, **characterised in that** the first and/or the second metal plate is perforated before being placed on the ceramic substrate.

11. A method according to Claim 10 above, **characterised in that**, before being placed on the ceramic substrate, the first and/or the second plate is provided with holes having a diameter of between 0.1 and 1 mm, but preferably between 0.4 and 0.6 mm.

12. A method according to Claim 10 or 11 above, **characterised in that** the said holes are arranged in columns and rows at equal intervals.

## Revendications

1. Procédé de fabrication de substrats en céramique et en métal métallisés sur les deux faces d'après un procédé de liaison directe, dans lequel
un assemblage constitué d'une première plaque de métal et d'une deuxième plaque en métal et d'un substrat en céramique disposé entre la première et la deuxième plaque en métal est déposé sur un support qui est structuré sur la face supérieure, qui est tournée vers l'assemblage constitué de la première et la deuxième plaque en métal et du substrat en céramique, en formant une multitude de points d'appui, et
l'assemblage constitué des première deuxième plaques en métal et du substrat en céramique reposant sur le support étant lié par chauffage au substrat en céramique et métal métallisé sur les deux faces,
**caractérisé en ce que**
le support présente une multitude de plots saillants qui s'amincissent en direction de l'assemblage constitué de la première et de la deuxième plaque en métal et du substrat en céramique, sur la face supérieure qui est tournée vers l'assemblage constitué de la première et la deuxième plaque en métal et du substrat en céramique, où
l'assemblage constitué de la première et de la deuxième plaque en métal et du substrat en céramique disposé entre la première et la deuxième plaque en métal est placée sur les plots saillants du support sans insertion intermédiaire d'une couche de séparation.

2. Procédé selon l'une des revendications 1, **caractérisé en ce que** les plots saillants se finissent en pointe dans la direction de l'assemblage constitué de la première et de la deuxième plaque de métal et du substrat en céramique.

3. Procédé selon la revendication 1 ou 2, **caractérisé en ce que** les plots saillants sont des corps coniques.

4. Procédé selon la revendication 1 ou 2, **caractérisé en ce que** les plots saillants sont des corps pyramidaux.

5. Procédé selon la revendication 1 ou 2, **caractérisé en ce que** les plots saillants sont des corps hémisphériques.

6. Procédé selon l'une des revendications 1 à 5, **caractérisé en ce que** les plots saillants sont répartis à intervalles réguliers sur la face supérieure du substrat qui est tournée vers l'assemblage constitué de la première et de la deuxième plaque en métal et du substrat en céramique.

7. Procédé selon l'une des revendications 1 à 6, **caractérisé en ce que** le support ou du moins des parties du support présentent au moins un des composés choisis dans le groupe constitué par la mullite, le nitrure d'aluminium, le nitrure de bore, le nitrure de silicium, le nitrure de zirconium, le carbure de silicium et le graphite.

8. Procédé selon l'une des revendications 1 à 7, **caractérisé en ce que** les plaques en métal sont oxydées avant l'application sur le substrat en céramique.

9. Procédé selon l'une des revendications 1 à 8, **caractérisé en ce que** l'on utilise des plaques en cuivre comme plaques en métal.

10. Procédé selon l'une des revendications 1 à 9, **caractérisé en ce que** la première et/ou la deuxième plaque en métal est perforée avant le dépôt sur le substrat en céramique.

11. Procédé selon la revendication 10, **caractérisé en ce que** la première et/ou la deuxième plaque en métal est dotée de trous qui ont un diamètre qui se situe entre 0,1 et 1 mm, de préférence de 0,4 à 0,6 mm, avant le dépôt sur le substrat en céramique.

12. Procédé selon la revendication 10 ou 11, **caractérisé en ce que** les trous sont disposés en lignes et en colonnes de préférence à intervalles réguliers.
